(19) **Europäisches Patentamt / European Patent Office / Office européen des brevets**

(11) **EP 2 485 270 A1**

(12) **EUROPEAN PATENT APPLICATION**
published in accordance with Art. 153(4) EPC

(43) Date of publication:
**08.08.2012 Bulletin 2012/32**

(51) Int Cl.:
**H01L 31/042** (2006.01)

(21) Application number: **10820401.7**

(22) Date of filing: **21.09.2010**

(86) International application number:
**PCT/JP2010/066301**

(87) International publication number:
**WO 2011/040282 (07.04.2011 Gazette 2011/14)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **29.09.2009 JP 2009224022**

(71) Applicant: **Toppan Printing Co., Ltd.**
**Tokyo 110-0016 (JP)**

(72) Inventors:
• **HIRATA Tatsu**
**Tokyo 110-0016 (JP)**
• **KAMESHIMA Hisamitsu**
**Tokyo 110-0016 (JP)**
• **MATSUSHIMA Atsushi**
**Tokyo 110-0016 (JP)**

(74) Representative: **Andrews, Timothy Stephen**
**Marks & Clerk LLP**
**66-68 Hills Road**
**Cambridge**
**CB2 1LA (GB)**

(54) **SEALING MATERIAL SHEET FOR SOLAR BATTERY MODULE, AND PROCESS FOR PRODUCTION OF SOLAR BATTERY MODULE**

(57) Disclosed are a sealing material sheet for a solar cell module and a method of manufacturing a solar cell module capable of reducing damage to a photoelectric conversion cell and leakage of a sealing material during manufacturing of a solar cell module, and easily manufacturing a high-quality solar cell module. A sealing material sheet for a solar cell module includes transparent resin (A) exhibiting an MFR (190°C, 2.16 kg load) of 10 to 20 g/10 min and transparent resin (B) exhibiting an MFR (190°C, 2.16 kg load) of 30 to 40 g/10 min. The mass ratio $\alpha$ (=$W_A/W_B$) of the transparent resin (A) (mass: $W_A$) and the transparent resin (B) (mass: $W_B$) is 0.7 to 1.5. A solar cell module uses the sealing material sheet for a solar cell module.

FIG. 1

EP 2 485 270 A1

**Description**

TECHNICAL FIELD

The present invention relates to a sealing material sheet for a solar cell module and a method of manufacturing a solar cell module using the sealing material sheet for a solar cell module.
Priority is claimed on Japanese Patent Application No. 2009-224022, filed September 29, 2009, the content of which is incorporated herein by reference.

BACKGROUND ART

As a clean power generation technique using sunlight, a solar cell has recently attracted attention. In general, a solar cell module has a layer configuration in which a sealing material layer with a photoelectric conversion cell generating power using sunlight sealed with a sealing material is interposed between a front protective member and a rear protective member.
As a method of manufacturing a solar cell module, the following method 1 is used in which two sealing material sheets for a solar cell module (hereinafter, simply referred to as "sealing material sheet") are used.

1. A method of manufacturing a solar cell module that includes laminating a front protective member, a first sealing material sheet, a photoelectric conversion cell, a second sealing material sheet, and a rear protective member in that order to form a laminate, heating the laminate in a vacuum to deaerate the laminate, heating the laminate while applying a load of 1 atmosphere in a vacuum to bury the photoelectric conversion cell in the first sealing material sheet and the second sealing material sheet, and cross-linking and hardening resin of the sealing material sheet to bond and combine the sealing material sheet as a single body.

However, in the method (1), when the photoelectric conversion cell is buried in the sealing material sheet, since the sealing material sheet is strongly pressed against the photoelectric conversion cell, the photoelectric conversion cell may be damaged due to the pressing force. Accordingly, as a method which prevents the photoelectric conversion cell from being damaged, the following manufacturing method is described.

(2) A method of manufacturing a solar cell module that uses a sealing material sheet having a low elastic modulus to decrease a pressing force of the sealing material sheet against a photoelectric conversion cell when sealing the photoelectric conversion cell, thereby reducing damage to the photoelectric conversion cell (for example, Patent Document 1).
(3) A method of manufacturing a solar cell module that uses a sealing material sheet in which a concave portion is provided in the surface by embossing to distribute a pressing force of the sealing material sheet against a photoelectric conversion cell when sealing the photoelectric conversion cell, thereby reducing damage to the photoelectric conversion cell (for example, Patent Document 2).

PRIOR ART DOCUMENTS

PATENT DOCUMENTS

(Patent Document 1) International Publication No. 06/095762
(Patent Document 2) International Publication No. 01/061763

DISCLOSURE OF INVENTION

PROBLEMS TO BE SOLVED BY THE INVENTION

However, in the method (2), since the elastic modulus of the sealing material sheet is low, the sealing material may be extruded and may leak a lot outside the effective area of the solar cell module when sealing the photoelectric conversion cell.
In the method (3), air in the concave portion provided in the surface of the sealing material sheet is likely to remain in the sealing material layer of the solar cell module. Since the deeper the concave portion, the greater the amount of air, the time necessary for deaeration increases.

From the above, there is demand for developing a method capable of reducing damage to a photoelectric conversion cell and leakage of a sealing material, and easily manufacturing a high-quality solar cell module.

An object of the present invention is to provide a sealing material sheet for a solar cell module and a method of manufacturing a solar cell module capable of reducing damage to a photoelectric conversion cell and leakage of a sealing material when sealing the photoelectric conversion cell, and easily manufacturing a high-quality solar cell module.

MEANS FOR SOLVING THE PROBLEMS

The present invention uses the following configuration so as to solve the above-described problem.

(1) A sealing material sheet for a solar cell module includes transparent resin (A) exhibiting a melt flow rate (190°C, 2.16 kg load) of 10 to 20 g/10 min and transparent resin (B) exhibiting a melt flow rate (190°C, 2.16 kg load) of 30 to 40 g/10 min. The mass ratio $\alpha$ (=$W_A/W_B$) of the transparent resin (A) (mass: $W_A$) and the transparent resin (B) (mass: $W_B$) is 0.7 to 1.5.

(2) The sealing material sheet described in (1) has a mixed resin layer including a mixed resin of the transparent resin (A) and the transparent resin (B).

(3) The sealing material sheet described in (1) has a laminate in which a transparent resin layer (a) including the transparent resin (A) and a transparent resin layer (b) including the transparent resin (B) are laminated such that at least one of foremost layers of the laminate is the transparent resin layer (b).

(4) In the sealing material sheet described in (3), the laminate is formed by coextrduing the transparent resin (A) and the transparent resin (B).

(5) In the sealing material sheet described in any one of (1) to (4), the thickness is 10 to 500 $\mu$m.

(6) A method of manufacturing a solar cell module includes a sealing step of heating and pressing in a state where a photoelectric conversion cell is interposed between the sealing material sheets for a solar cell module described in (1) to seal the photoelectric conversion cell by the sealing material sheet for a solar cell module.

(7) In the method described in (6), the photoelectric conversion cell is interposed between the sealing material sheets for a solar cell module described in (3) or (4) such that the transparent resin layer (b) of the foremost layer of the sealing material sheet for a solar cell module turns toward the photoelectric conversion cell.

EFFECTS OF THE INVENTION

The sealing material sheet for a solar cell module of the present invention can reduce damage to a photoelectric conversion cell and leakage of a sealing material during manufacturing of a solar cell module.

According to the manufacturing method of the present invention, with the use of the sealing material sheet for a solar cell module of the present invention, it is possible to reduce damage to a photoelectric conversion cell and leakage of a sealing material when sealing the photoelectric conversion cell, and to easily manufacture a high-quality solar cell module.

BRIEF DESCRIPTION OF DRAWINGS

Fig. 1 is a sectional view showing an example of an embodiment of a solar cell module of the present invention.
Fig. 2 is a sectional view showing one step in a method of manufacturing a solar cell module of the present invention.
Fig. 3 is a sectional view showing one step in a method of manufacturing a solar cell module of the present invention.
Fig. 4 is a sectional view showing a sample for measurement of adhesion strength between a sealing material sheet and a protective member.
Fig. 5 is a plan view showing the range of leakage of a sealing material in solar cell modules of Examples and Comparative Examples.

EMBODIMENTS FOR CARRYING OUT THE INVENTION

Sealing Material Sheet for Solar Cell Module

A sealing material sheet of the present invention is a sheet which is used to seal a photoelectric conversion cell in a solar cell module, and includes transparent resin (A) and transparent resin (B) exhibiting different melt flow rates (hereinafter, referred to as "MFR").

The MFR of transparent resin in the present invention is an index which represents resin fluidity, and means a value which is measured under the conditions of 190°C and 2.16 kg load by a method based on JIS K7210. The transparent resin in the present invention refers to a resin whose total light transmittance measured by a method based on JIS K710S is equal to or greater than 85% at the thickness of 0.5 mm.

Transparent Resin (A)

The MFR (190°C, 2.16 kg load) of the transparent resin (A) is 10 to 20 g/10 min. The transparent resin (A) has the effect of reducing leakage of a sealing material outside a protective member (front protective member, rear protective member).

If the transparent resin (A) exhibiting the MFR in the above-described range is used along with transparent resin (B) described below, it is possible to reduce both damage to a photoelectric conversion cell and leakage of a sealing material during manufacturing of a solar cell module.

As the transparent resin (A), known high-transparency resin which is typically used in a sealing material sheet may be used. Examples of such resin include polyolefin, such as polyethylene or polypropylene; an ionomer; an ethylene-vinyl acetate copolymer (hereinafter, referred to as "EVA"); an ethylene-methacrylic acid copolymer; an ethylene-acrylic acid copolymer; polyvinyl fluoride; polyvinyl chloride or a copolymer thereof. Particularly, from the viewpoint of excellent transparency and low cost, EVA is preferably used.

The MFR of a cross-linking ethylene-based copolymer can be adjusted by adjusting the content of a unit resulting from a copolymeric component in the copolymer. For example, the MFR of EVA can be adjusted by adjusting the content of a vinyl acetate unit in 100% by mass of EVA.

When EVA is used as the transparent resin (A) (MFR: 10 to 20 g/10 min), the content of a vinyl acetate unit in 100% by mass of EVA is preferably 10 to 40% by mass, and more preferably, 20 to 30% by mass.

The MFR can also be adjusted by adjusting the molecular weight. As the molecular weight increases, the MFR decreases.

Although EVA is preferably used as the transparent resin (A), other types of resin may be added within the scope without interfering with the object of the present invention.

In regard to the transparent resin (A), one type may be used alone, or two or more types may be used in combination.

Transparent Resin (B)

The MFR (190°C, 2.16 kg load) of the transparent resin (B) is 30 to 40 g/10 min. The transparent resin (B) has the effect of reducing damage to a photoelectric conversion cell during manufacturing of a solar cell module.

If the transparent resin (B) exhibiting the MFR in the above-described range is used along with the transparent resin (A), it is possible to reduce both damage to a photoelectric conversion cell and leakage of a sealing material during manufacturing of a solar cell module.

As the transparent resin (B), the same resin as resin as the transparent resin (A) may be used. In regard to the transparent resin (B), from the viewpoint of excellent transparency and low cost, EVA is preferably used. The MFR of the transparent resin (B) can be adjusted by the method described in the transparent resin (B).

When EVA is used as the transparent resin (B) (MFR: 30 to 40 g/10 min), the content of a vinyl acetate unit in 100% by mass of EVA is preferably 10 to 40% by mass, and more preferably, 30 to 35% by mass.

Although EVA is preferably used as the transparent resin (B), other types of resin may be added within the scope without interfering with the object of the present invention.

In regard to the transparent resin (B), one resin may be used alone, or two or more resins may be used in combination.

In the sealing material sheet of the present invention, although the transparent resin (A) and the transparent resin (B) are different types of transparent resin, it is preferable that the transparent resin (A) and the transparent resin (B) be the same type of transparent resin. Both the transparent resin (A) and the transparent resin (B) preferably include EVA, and in particular, consist of EVA.

The mass ratio $\alpha$ ($=W_A/W_B$) of the transparent resin (A) (mass: $W_A$) and the transparent resin (B) (mass: $W_B$) is 0.7 to 1.5. If the mass ratio $\alpha$, of the transparent resin (A) and the transparent resin (B) is in the above-described range, it is possible to reduce damage to a photoelectric conversion cell and leakage of a sealing material when sealing the photoelectric conversion cell during manufacturing of a solar cell module. The larger the mass ratio $\alpha$, the higher the effect of reducing leakage of a sealing material. The smaller the mass ratio $\alpha$, the higher the effect of reducing damage to a photoelectric conversion cell. The mass ratio $\alpha$ of the transparent resin (A) and the transparent resin (B) is preferably 0.9 to 1.1, and more preferably, 1.0.

Transparent Resin (C)

In the sealing material sheet of the present invention, although transparent resin preferably includes the transparent resin (A) and the transparent resin (B), transparent resin (C) other than the transparent resin (A) and the transparent resin (B) may be included within the scope capable of reducing damage to a photoelectric conversion cell and leakage of a sealing material during manufacturing of a solar cell module.

As the transparent resin (C), transparent resin exhibiting an MFR (190°C, 2.16 kg load) smaller than 10 g/10 min, transparent resin exhibiting an MFR greater than 20 g/10 min and smaller than 30 g/10 min, transparent resin exhibiting an MFR greater than 40 g/10 min, or the like may be used. Examples of transparent resin include the types described in the transparent resin (A).

Other Components

In the sealing material sheet of the present invention, a cross-linker may be added so as to increase strength within the scope without interfering with transparency.

Examples of the cross-linker include 1,1-di(t-butylperoxy)cyclohexane, 1,1-di(t-hexylperoxy)cyclohexane, n-butyl-4,4-di-(t-butylperoxy)valerate, t-butylperoxy-3,5,5-trimethylhexanoate, 2,5-dimethyl-2,5-di(t-butylperoxy)hexane, t-butylcumylperoxide, 2,2-di-(t-butylperoxy)butane, and the like.

In the sealing material sheet, in addition to the cross-linker, a cross-linking aid may be added so as to promote a cross-linking reaction. Examples of the cross-linking aid include triallyl isocyanurate, diallyl phthalate, triallyl cyanurate, and the like.

A silane-coupling agent which is used to improve adhesiveness, an ultraviolet absorbent which is used to improve light resistance, and an antioxidant which is used to improve thermal stability may be added.

Examples of the silane-coupling agent include $\gamma$-methacryloxypropyltrimethoxysilane, trimethoxypropylsilane, trimethoxymethylsilane, vinyltrimethoxysilane, vinyltriethoxysilane, trichloropropylsilane, triethoxyphenylsilane, and the like.

Example of the ultraviolet absorbent include

2-(5-methyl-2-hydroxyphenyl)benzotriazole,
2-(3-t-butyl-5-methyl-2-hydroxyphenyl)-5-chlorobenzotriazole,
2-(4,6-diphenyl-1,3,5-triazine-2-yl)-5-[(hexyl)oxy]-phenol, 2,4-dihydroxybenzophenone,
2-hydroxy-4-n-octyloxybenzophenone, and the like.

Examples of the antioxidant include

1,6-hexanediol-bis[3-(3,5-di-t-butyl-4-hydroxyphenyl)propionate],
pentaerythrityl-tetrakis[3-(3,5-di-t-butyl-4-hydroxyphenyl)propionate],
tris(2,4-di-t-butylphenyl)phosphite,
2,4-bis-(n-octylthio)-6-(4-hydroxy-3,5-di-t-butylanilion)-1,3,5-triazine, and the like.

The sealing material sheet of the present invention may be a single-layer sheet or a multilayer sheet. When the sealing material sheet of the present invention has multiple layers, the mass ratio $\alpha$ of the transparent resin (A) and the transparent resin (B) is the mass ratio of the total mass of the transparent resin (A) included in all the layers and the total mass of the transparent resin (B) included in all the layers. The sealing material sheet of the present invention is preferably the following sealing material sheet (i) and sealing material sheet (ii), and from the viewpoint of adhesiveness, particularly preferably the sealing material sheet (i).

(i) A sealing material sheet that has a mixed resin layer including a mixed resin of the transparent resin (A) and the transparent resin (B).
(ii) A sealing material sheet that has a laminate in which a transparent resin layer (a) including the transparent resin (A) and a transparent resin layer (b) including the transparent resin (B) are laminated such that at least one of foremost layers of the laminate is the transparent resin (b).

Sealing Material Sheet (i):

The sealing material sheet (i) is a sheet which includes a mixed resin layer formed of a resin composition including a mixed resin of the transparent resin (A) and the transparent resin (B) and, if necessary, a cross-linker, a cross-linking aid, a silane-coupling agent, or the like. Although the mixed resin layer may have a single layer or multiple layers, the mixed resin layer preferably has a single layer. When the sealing material sheet (i) includes the mixed resin layer having two or more layers, it is preferable that each layer be formed by coextrusion.

The thickness of the sealing material sheet (i) is preferably 10 to 500 $\mu$m, and more preferably, 400 to 500 $\mu$m. When the sealing material sheet (i) has multiple layers, the thickness is the total thickness of all the layers.

In the solar cell module, sealing material layers which come into contact with front and rear protective members are soft layers because adhesiveness to these members is emphasized over hardenability. For this reason, if the thickness of the sealing material sheet (i) exceeds 500 $\mu$m, the deformation of the sealing material layer may increase due to stress caused by distortion of the protective member, and airtightness of the end portion of the layer may be degraded, causing deterioration in a photoelectric conversion cell or a circuit. If the thickness of the sealing material sheet (i) is smaller than 10 $\mu$m, processability is degraded, and a void is likely to occur in the sealing material layer. Accordingly, adhesiveness and sealability of the void portion to the protective member may be degraded, causing deterioration in a photoelectric conversion cell or a circuit.

The sealing material sheet (i) can be manufactured by film-forming the heated and molten resin composition by a T-die method or a colander method. In the film-forming step, embossing may be performed on the sealing material sheet in which a roller (made of metal or rubber) with a corrugated pattern is pressed against the surface of the sealing material sheet (i) in the heated and molten state to transfer the corrugated pattern of the roller to one surface or both surfaces of the sealing material sheet (i).

During embossing, it is preferable that the corrugated pattern in the roller for the film-forming step be selected such that the void ratio P which is defined by a percentage $V_H/V_A\times100\%$ of the total volume $V_H$ of a concave portion per unit area of the sealing material sheet (i) and an apparent volume $V_A$ of the sheet obtained by multiplying the maximum thickness to the unit area to be 1 to 4%, and embossing is performed on the sealing material sheet.

The void ratio P defined by $V_H/V_A\times100\%$ can be calculated as follows. That is, in the sealing material sheet subjected to embossing, the apparent volume $V_A$ (mm$^3$) of the sealing material sheet is calculated by the product of the maximum thickness $t_{max}$ (mm) of the sealing material sheet and the unit area (for example, 1 m$^2$=1000×1000=10$^6$ mm$^2$) as follows.

$$V_A \ (\mathrm{mm}^3)=t_{max}\times10^6$$

The actual volume $V_0$ (mm$^3$) of the sealing material sheet of the unit area is calculated as follows from the specific gravity $\rho$ (g/mm$^3$) of resin forming the sealing material sheet and the actual weight W (g) of the sealing material sheet per unit area (1 m$^2$).

$$V_0 \ (\mathrm{mm}^3)=W/\rho$$

The total volume $V_H$ (mm$^3$) per unit area of the sealing material sheet is calculated by subtracting the actual volume $V_0$ from the apparent volume $V_A$ of the sealing material sheet as follows.

$$V_H \ (\mathrm{mm}^3)=V_A-V_0=V_A-(W/\rho)$$

Accordingly, the void ratio (%) can be obtained as follows.

$$\text{void ratio P (\%)} = V_H/V_A\times100 = (V_A-(W/\rho))/V_A\times100 = 1-W/(\rho\cdot V_A)\times100 =$$

$$1-W/(\rho\cdot tmax\cdot10^6)\times100$$

The void ratio (%) may be calculated by the above-described expression, or may be obtained by imaging the section of the sealing material sheet or the surface subjected to embossing using a microscope and performing an image process. The maximum thickness $t_{max}$ of the sealing material sheet represents the distance from the top portion of a convex portion to the rear surface when one surface of the sealing material sheet is subjected to embossing, and represents the distance between the tips of convex portions of both surfaces (the distance in the film thickness direction) when both surfaces of the film are subjected to embossing. The maximum thickness $t_{max}$ is preferably 50 to 2000 $\mu$m.

Sealing Material Sheet (ii):

The sealing material sheet (ii) is a sheet having a laminate in which a transparent resin layer (a) formed of a resin composition including the transparent resin (A) and, if necessary, a cross-linker, a cross-linking aid, a silane-coupling agent, or the like and a transparent resin layer (b) formed of a resin composition including the transparent resin (B) and, if necessary, a cross-linker, a cross-linking aid, a silane-coupling agent, or the like are laminated such that one or both of foremost layers of the laminate is the transparent resin (b). Such examples include a sealing material sheet having a laminate including a structure of such as: the transparent resin layer (a)/the transparent resin layer (b): the transparent resin layer (b)/the transparent resin layer (a)/the transparent resin layer (b); or a laminate having the transparent resin layer (a)/the transparent resin layer (b)/ the transparent resin layer (a)/the transparent resin layer (b). Particularly, from the viewpoint of adhesiveness, a sealing material sheet preferably has a laminate having the transparent resin layer (a)/the transparent resin layer (b).

The sealing material sheet (ii) uses the transparent resin (b) of the foremost layer toward the photoelectric conversion cell side during manufacturing of a solar cell module.

Although the laminate in the sealing material sheet (ii) is formed by individually forming the transparent resin layer (a) and the transparent resin layer (b) by a T-die method or a colander method and then laminating the transparent resin layer (a) and the transparent resin layer (b), it is preferable that the transparent resin layer (a) and the transparent resin layer (b) be formed by coextrusion.

In the sealing material sheet (ii), similarly to the sealing material sheet (i), embossing may be performed.

For the same reason as the sealing material sheet (i), the thickness of the sealing material sheet (ii) is preferably 10 to 500 $\mu$m, and more preferably, 400 to 500 $\mu$m.

The ratio $d_a/d_b$ of the thickness da of the transparent resin layer (a) and the thickness db of the transparent resin layer (b) in the sealing material sheet (ii) is preferably 0.8 to 1.2, and more preferably, 0.9 to 1.1. If the ratio $d_a/d_b$ is equal to or greater than 0.8, it is easy to reduce leakage of a sealing material during manufacturing of a solar cell module. If the ratio $d_a/d_b$ is equal to or smaller than 1.2, it is easy to reduce damage to a photoelectric conversion cell during manufacturing of a solar cell module.

In the sealing material sheet of the related art, transparent resin exhibiting an MFR of 0.1 to 100 g/10 min is usually used, but in this sealing material sheet, it is difficult to reduce both damage to a photoelectric conversion cell and leakage of a sealing material. As a result of in-depth consideration of this problem, the inventors have found that the transparent resin (A) exhibiting the MFR of 10 to 20 g/min and the transparent resin (B) exhibiting the MFR of 30 to 40 g/min can be used together at a specific mass ratio, thereby reducing damage to a photoelectric conversion cell and leakage of a sealing material outside a protective member when sealing the photoelectric conversion cell during manufacturing of a solar cell module using the sealing material sheet. A conceivable reason is that if the transparent resin (A) and the transparent resin (B) exhibiting different MFRs are used together, the distribution of fluidity spreads, thereby exhibiting both the effect of reducing leakage of a sealing material by the transparent resin (A) and the effect of reducing damage to a photoelectric conversion cell by the transparent resin (B).

The sealing material sheet of the present invention is not limited to the above-described sealing material sheet. For example, the sealing material sheet may be a sealing material sheet in which a mixed resin layer and the transparent resin layer (a) and/or the transparent resin layer (b) are laminated. In this case, in the sealing material sheet, at least one of foremost layers may be the mixed resin layer (when the mass ratio $\alpha$ in the mixed resin layer is 0.7 to 1.5) or the transparent resin layer (b).

Method of Manufacturing Solar Cell Module

A method of manufacturing a solar cell module of the present invention has a sealing step of sealing a photoelectric conversion cell using the sealing material sheet of the present invention. That is, as the method of manufacturing a solar cell module of the present invention, a known method can be applied, except that the sealing material sheet of the present invention is used.

As the method of manufacturing a solar cell module of the present invention, the following methods (I) and (II) may be used depending on the difference in the form of the sealing material sheet of the present invention.

(I) A method has a sealing step of heating and pressing in a state where a photoelectric conversion cell is interposed between the sealing material sheets (i) to seal the photoelectric conversion cell with the sealing material sheet (i).
(II) A method has a sealing step of heating and pressing in a state where a photoelectric conversion cell is interposed between the sealing material sheets (ii) such that the transparent resin layer (b) of the foremost layer of the sealing material sheet (ii) turns toward the photoelectric conversion cell side, to seal the photoelectric conversion cell with the sealing material sheet (ii).

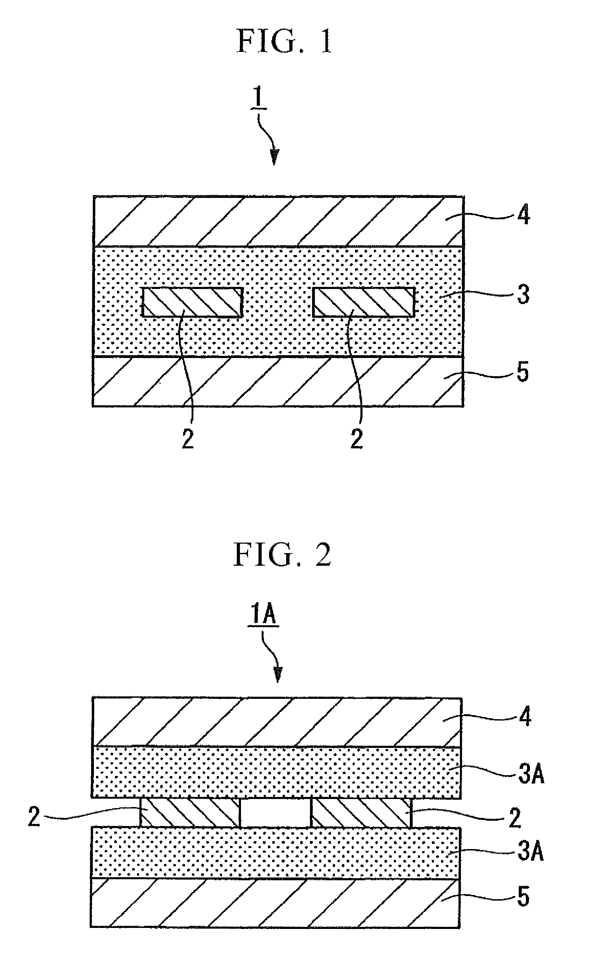

Hereinafter, as an example of an embodiment of a method of manufacturing a solar cell module of the present invention, as shown in Fig. 1, a method of manufacturing a solar cell module 1 having photoelectric conversion cells 2 and 2 generating power using sunlight, a sealing material layer 3 sealing the photoelectric conversion cells 2 and 2, a front protective member 4 protecting the front surface of the sealing material layer 3, and a rear protective member 5 protecting the rear surface of the sealing material layer 3 will be described in detail.

Method (I):

The method (I) has the following steps.
Lamination Step: As shown in Fig. 2, the rear protective member 5, the sealing material sheet (i) 3A, the photoelectric conversion cells 2 and 2, the sealing material sheet (i) 3A, and the front protective member 4 are laminated in that order, thereby obtaining a laminate 1A.
Sealing Step: The laminate 1A is heated and pressed, and the photoelectric conversion cells 2 and 2 are sealed with the sealing material sheets (i) 3A and 3A, thereby forming the sealing material layer 3.
In the sealing step, the sealing material sheets (i) 3A and 3A are pressed against the photoelectric conversion cells 2 and 2 by vacuum lamination in which the laminate 1A is heated and pressed in the vacuum state, the photoelectric conversion cells 2 and 2 are buried in the sealing material sheets (i) 3A and 3A, and the transparent resin of the sealing material sheets (i) 3A and 3A are cross-linked and hardened to be then bonded and combined as a single body, thereby forming the sealing material layer 3. Thus, the solar cell module 1 is obtained.
The vacuum state means that the pressure is equal to or lower than 133 Pa (about 1 mmHg).
After being placed in a vacuum for 3 minutes, it is preferable that the vacuum on the rear protective member side be released, and pressing be performed from the rear protective member at 101325 Pa (atmospheric pressure).
During sealing, the heating temperature is preferably 150°C.

Method (II):

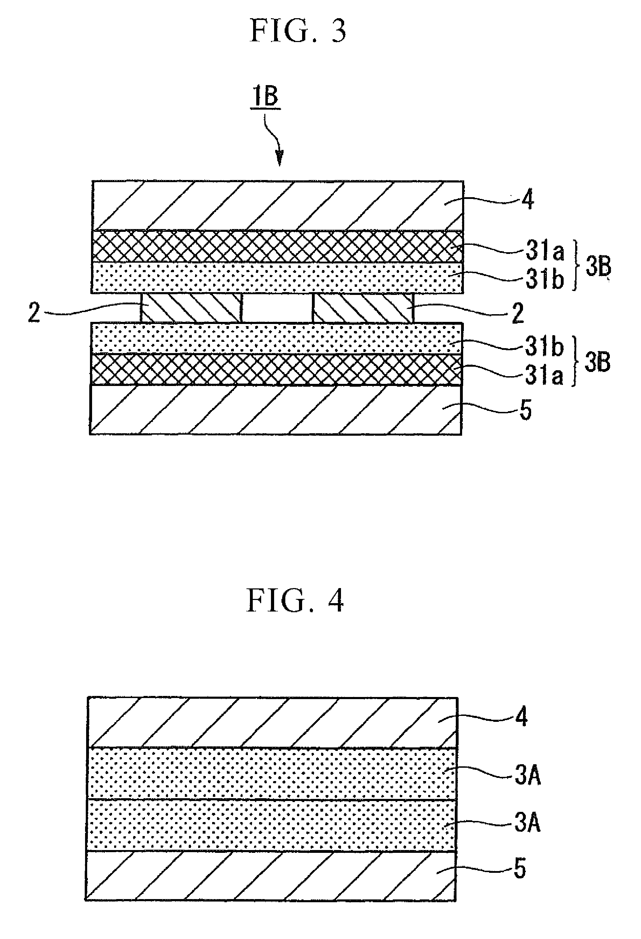

The method (II) has the following steps.
Lamination Step: As shown in Fig. 3, a sealing material sheet (ii) 3B in which a transparent resin layer (a) 31a and a transparent resin layer (b) 31b are laminated is used, and a rear protective member 5, a sealing material sheet (ii) 3B, photoelectric conversion cells 2 and 2, a sealing material sheet (ii) 3B, and a front protective member 4 are laminated in that order such that the transparent resin layer (b) 31b turns toward the photoelectric conversion cells 2 and 2, thereby obtaining a laminate 1B.
Sealing Step: The laminate 1B is heated and pressed, and the photoelectric conversion cells 2 and 2 are sealed with the sealing material sheets (ii) 3B and 3B, thereby forming the sealing material layer 3.
In the lamination step of the method (II), a transparent resin layer (b) which has excellent flexibility and is effective for reducing damage to the photoelectric conversion cell 2 when being pressed against the photoelectric conversion cell 2 is laminated toward the photoelectric conversion cell 2.
The sealing step can be performed in the same manner as the sealing step of the method (I).
Hereinafter, materials, other than the sealing material sheet, which are used for manufacturing the solar cell module 1 will be described.
The photoelectric conversion cell 2 is a cell having a function of converting light incident on a light receiving surface to electricity by a photoelectric effect. A plurality of (in Fig. 1, two) photoelectric conversion cells 2 are connected by electrodes (not shown) in the solar cell module 1.
As the material for the photoelectric conversion cell 2, a known material which is used in photoelectric conversion cells can be used. For example, crystalline silicon, such as single-crystal silicon or polysilicon, may be used. Of these, from the viewpoint of ease of manufacturing and low cost, polysilicon is preferably used.
As the front protective member 5, a protective member having excellent weather resistance, durability, transparency, or the like is preferably used. For example, a glass plate, a resin sheet, such as polyethylene terephthalate, or the like is used. A resin sheet, such as polycarbonate, may also be used.
The thickness of the front protective member 5 is preferably 0.2 to 3.0 mm.
As the rear protective member 6, a protective member having excellent weather resistance and durability is preferably used. For example, a resin sheet, such as polyethylene terephthalate, polyvinyl fluoride, or EVA, a laminate thereof, or the like is used. In order to impose a water vapor barrier property or an oxygen barrier property, a barrier layer may be laminated on the resin sheet or the laminate.
The thickness of the rear protective member 6 is preferably 0.1 to 1.0 mm.
In the solar cell module 1, when EVA is used as the transparent resin (A) and (B), the cross-linking ratio of EVA in the sealing material layer 3 after having heated and pressed in the vacuum state is preferably equal to or greater than 70%.
The cross-linking ratio is obtained by stripping off the sealing material layer 3 of the solar cell module 1 after having been heated and pressed, dipping 1 g of the sealing material layer 3 in 100 cc of xylene, melting the sealing material layer 3 for 12 hours at 110°C, measuring the mass of an unmolten component, and calculating the mass ratio in the following expression.

$$(\text{Cross-Linking Ratio}) = [\text{Mass (g) of Unmolten Component/Mass (1g) Before Melting}] \times 100$$

The adhesive strength of the protective member (the front protective member 4, the rear protective member 5) and the sealing material layer 3 in the solar cell module 1 is preferably equal to or greater than 30 N/15 mm. The adhesive strength is measured by the following measurement method.

As shown in Fig. 4, the rear protective member 5, the sealing material sheet (i) 3A, the sealing material sheet (i) 3A, and the front protective member 4 are superimposed in that order, and vacuum pressing at 101325 Pa is performed for 10 minutes at 150°C, thereby producing a pseudo module. White plate glass (3 mm thickness) is used as the front protective member, and vinyl fluoride polymer (38 $\mu$m thickness) is used as the rear protective member.

In regard to the adhesive strength between the front protective member and the sealing material layer, an incision as the start of separation is made in the interface of the front protective member 4 and the sealing material sheet (i) 3A in the pseudo module by a cutter, the sealing material layer and the rear protective member are fixed onto a chuck of an adhesive strength measurement instrument, and the adhesive strength is measured at an angle of 90°.

As the adhesive strength measurement instrument, TENSILON (RTC-1250) manufactured by ORIENTEC is used. The measurement condition is that adhesive strength measurement with a width of 15 mm is made, and the separation rate is 30 mm/min.

In regard to the adhesive strength between the rear protective member and the sealing material, an incision as the start of separation was made in the interface of the rear protective member 5 and the sealing material sheet (i) 3A by a cutter, the rear protective member 5 was fixed onto the chuck of the adhesive strength measurement instrument, and the adhesive strength was measured at an angle of 90°. The adhesive strength measurement instrument and the measurement condition are the same as during adhesive strength measurement of the front protective member and the sealing material.

When the sealing material sheet (ii) 3B is used, the same operation is performed.

According to the manufacturing method of the present invention described above, it is possible to reduce damage to a photoelectric conversion cell and leakage of a sealing material during manufacturing, and to easily manufacture a solar cell module with high productivity.

The method of manufacturing a solar cell module of the present invention is not limited to the above-described method. For example, a method which uses the sealing material sheet (i) and the sealing material sheet (ii) in combination may be used. Examples

Hereinafter, the present invention will be described in detail in connection with Examples and Comparative Examples. However, it should be noted that the present invention is not limited to the following description.

Evaluation Method

In this example, evaluation was made as follows.

(Evaluation of Cell Damage)

As shown in Fig. 2, the front protective member 4 (white plate glass; vertical 290 mm $\times$ horizontal 210 mm $\times$ thickness 3 mm), the sealing material sheet 3A (the sealing material sheet obtained in each example; vertical 280 mm $\times$ horizontal 200 mm), two photoelectric conversion cells 2, the sealing material sheet 3A (the sealing material sheet obtained in each example; vertical 280 mm $\times$ horizontal 200 mm), and the rear protective member 5 (polyvinyl fluoride; vertical 290 mm $\times$ horizontal 210 mm) were laminated in that order, and vacuum lamination was made for 10 minutes at 150°C. Thereafter, damage to the cell was visually confirmed from the front protective member 4 side. This operation was done 50 times, and evaluation was made by the following standard,

"O": The number of times of damage to the photoelectric conversion cell was 0.
"△": The number of times of damage to the photoelectric conversion cell was equal to or greater than 1 and smaller than 3.
"✕": The number of times of damage to the photoelectric conversion cell was equal to or greater than 3.

(Evaluation of Sealing Material Leakage)

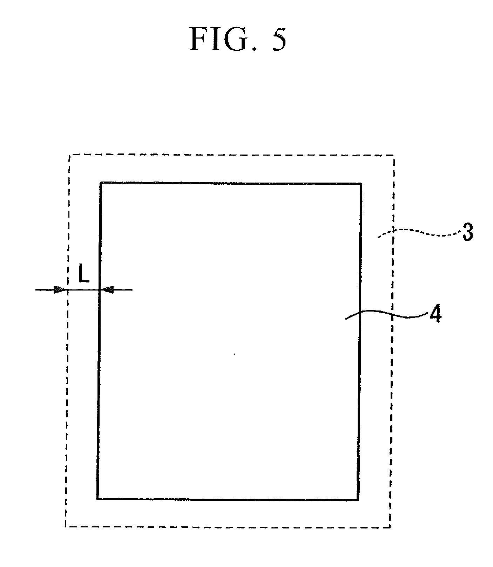

Similarly to "Evaluation of Cell Damage", a solar cell module was produced, as shown in Fig. 5, the maximum value of the distance L from the edge of the leaked sealing material 3 to the edge of the front protective member 4 was measured, and evaluation was made by the following standard.

"O": The maximum value of the distance L was smaller than 2 mm.
"Δ": The maximum value of the distance L was equal to or greater than 2 mm and smaller than 5 mm.
"x": The maximum value of the distance L was equal to or greater than 5 mm.

Hereinafter, raw materials used in this example are described.

(Transparent Resin (A))

Transparent resin A1: EVA (MFR: 10 g/10 min, vinyl acetate unit: 30% by mass)
Transparent resin A2: EVA (MFR: 20 g/10 min, vinyl acetate unit: 28% by mass)

(Transparent Resin (B))

Transparent resin B1: EVA (MFR: 30 g/10 min, vinyl acetate unit: 30% by mass)
Transparent resin B2: EVA (MFR: 40 g/10 min, vinyl acetate unit: 33% by mass)

(Transparent Resin (C))

Transparent resin C1: EVA (MFR: 5 g/10 min, vinyl acetate unit: 30% by mass)
Transparent resin C2: EVA (MFR: 25 g/10 min, vinyl acetate unit: 30% by mass)
Transparent resin C3: EVA (MFR: 50 g/10 min, vinyl acetate unit: 30% by mass)

(Cross-Linker)

cross-linker D1: 2,5-dimethyl-2,5-di(t-butylperoxy)hexane (organic peroxide)

(Cross-Linking Aid)

cross-linking aid E1: triallyl isocyanurate

(Silane-Coupling Agent)

Silane-Coupling Agent F1:γ-methacryloxypropyltrimethoxysilane

Example 1

A resin composition in which 0.375 parts by mass of a cross-linker D1, 0.375 parts by mass of a cross-linking aid E1, and 0.25 parts by mass of a silane-coupling agent F1 were added to 100 parts by mass of mixed resin (mass ratio a=1.0) of equal parts of transparent resin A 1 and transparent resin B1 was prepared.
Next, the resin composition was molded by an extrusion molding machine, and a sealing material sheet having a thickness of 0.4 mm was obtained. The thickness of the sealing material sheet was measured using an electronic micrometer (K351C manufactured by Anritsu Corporation).

Examples 2 to 4

Sealing material sheets were obtained in the same manner as in Example 1, except that the types of transparent resin included in the resin composition were changed as shown in Table 1.

Comparative Examples 1 to 5

Sealing material sheets were obtained in the same manner as in Example 1, except that the types of transparent resin included in the resin composition were changed to one type shown in Table 1.

Comparative Examples 6 to 13

Sealing material sheets were obtained in the same manner as in Example 1, except that the types of transparent resin included in the resin composition were changed as shown in Table 1.
The evaluation results of Examples 1 to 4 and Comparative Examples 1 to 13 are shown in Table 1.
Table 1

| | Transparent Resin | | | | Cell Damage | Sealing Material Leakage |
| | (1) | | (2) | | | |
| | Type | MFR [g/10 min] | Type | MFR [g/10 min] | | |
| Example 1 | A1 | 10 | B1 | 30 | O | O |
| Example 2 | A1 | 10 | B2 | 40 | O | O |
| Example 3 | A2 | 20 | B1 | 30 | O | O |
| Example 4 | A2 | 20 | B2 | 40 | O | O |
| Comparative Example 1 | A1 | 10 | - | - | × | O |
| Comparative Example 2 | A2 | 20 | - | - | Δ | O |
| Comparative Example 3 | B1 | 30 | - | - | Δ | Δ |
| Comparative Example 4 | B2 | 40 | - | - | O | Δ |
| Comparative Example 5 | C3 | 50 | - | - | O | × |
| Comparative Example 6 | C1 | 5 | B1 | 30 | × | O |
| Comparative Example 7 | C1 | 5 | B2 | 40 | × | O |
| Comparative Example 8 | C1 | 5 | C3 | 50 | Δ | Δ |
| Comparative Example 9 | A1 | 10 | C3 | 50 | Δ | Δ |
| Comparative Example 10 | A2 | 20 | C3 | 50 | Δ | × |
| Comparative Example 11 | C2 | 25 | B1 | 30 | Δ | Δ |
| Comparative Example 12 | C2 | 25 | B2 | 40 | Δ | Δ |

(continued)

|  | Transparent Resin | | | | Cell Damage | Sealing Material Leakage |
|  | (1) | | (2) | | | |
|  | Type | MFR [g/10 min] | Type | MFR [g/10 min] | | |
|---|---|---|---|---|---|---|
| Comparative Example 13 | C2 | 25 | C3 | 50 | O | × |

As shown in Table 1, in the sealing material sheets of Examples 1 to 4 using a mixed resin of the transparent resin (A) and the transparent resin (B) at the mass ratio $\alpha=1$, damage to the cell and leakage of the sealing material were reduced during manufacturing of the solar cell module.

In the sealing sheets of Comparative Examples 1 and 2 using only the transparent resin (A), it was not possible to reduce damage to the photoelectric conversion cell.

In the sealing material sheet of Comparative Example 3 using the transparent resin (B) exhibiting the MFR of 30 g/10 min, the effects of reducing damage to the photoelectric conversion cell and leakage of the sealing material were deteriorated compared to Example 4 using the transparent resin (A) exhibiting the MFR of 20 g/10 min and the transparent resin (B) exhibiting the MFR of 40 g/10 min were used in equal parts.

In the sealing material sheets of Comparative Example 4 using only the transparent resin (B) exhibiting the MFR of 40 g/10 min and Comparative Example 5 using only the transparent resin (C) exhibiting the MFR of 50 g/10 min, the sealing material leaked significantly.

In the sealing material sheets of Comparative Examples 6 to 13 in which two types of transparent resin exhibiting different MFRs were used and the combination was not the transparent resin (A) and the transparent resin (B), when the transparent resin (C) exhibiting the MFR of 5 g/10 min was used (Comparative Examples 6 to 8), it was not possible to reduce damage to the photoelectric conversion cell, and when the transparent resin (C) exhibiting the MFR of 50 g/min was used (Comparative Examples 8 to 10), it was not possible to reduce leakage of the sealing material. When the transparent resin (C) exhibiting the MFR of 25 g/10 min, which is a value intermediate between the transparent resin (A) and the transparent resin (B) was used (Comparative Examples 11 to 13), it was not possible to reduce both damage to the photoelectric conversion cell and leakage of the sealing material.

Next, the mass ratio $\alpha$ of the transparent resin (A) and the transparent resin (B) was considered.

Examples 5 and 6

Sealing material sheets were obtained in the same manner as in Example 1, except that transparent resin A2 and transparent resin B2 were used, and the mass ratio $\alpha$ of the transparent resin A2 and the transparent resin B2 was changed as shown in Table 2.

Comparative Examples 14 and 15

Sealing material sheets were obtained in the same manner as in Example 1, except that the transparent resin A2 and the transparent resin B2 were used, and the mass ratio $\alpha$ of the transparent resin A2 and the transparent resin B2 was changed as shown in Table 2. The evaluation results of Examples 4 to 6 and Comparative Examples 14 and 15 are shown in Table 2.

[Table 2]

|  | Transparent Resin (A) | | Transparent Resin (B) | | Mass Ratio $\alpha$ | Cell Damage | Sealing Material Leakage |
|  | Type | MFR [g/10 min] | Type | MFR [g/10 min] | | | |
|---|---|---|---|---|---|---|---|
| Example 4 | A2 | 20 | B2 | 40 | 1.0 | O | O |
| Example 5 | A2 | 20 | B2 | 40 | 0.7 | O | O |
| Example 6 | A2 | 20 | B2 | 40 | 1.5 | O | O |
| Comparative Example 14 | A2 | 20 | B2 | 40 | 0.5 | O | Δ |

(continued)

| | Transparent Resin (A) | | Transparent Resin (B) | | Mass Ratio $\alpha$ | Cell Damage | Sealing Material Leakage |
|---|---|---|---|---|---|---|---|
| | Type | MFR [g/10 min] | Type | MFR [g/10 min] | | | |
| Comparative Example 15 | A2 | 20 | B2 | 40 | 2.0 | $\Delta$ | O |

As shown in Table 2, in the sealing material sheets of Examples 4 to 6 in which the mass ratio $\alpha$ of the transparent resin (A) and the transparent resin (B) was in a range of 0.7 to 1.5, damage to the photoelectric conversion cell and leakage of the sealing material were reduced during manufacturing of the solar cell module.

In the sealing material sheet of Comparative Example 14 in which the mass ratio $\alpha$ of the transparent resin (A) and the transparent resin (B) was 0,5, it was not possible to sufficiently reduce leakage of the sealing material. In the sealing material sheet of Comparative Example 14 in which the mass ratio $\alpha$ of the transparent resin (A) and the transparent resin (B) was 2.0, it was not possible to sufficiently reduce damage to the photoelectric conversion cell.

DESCRIPTION OF THE REFERENCE SYMBOLS

1: solar cell module
2: photoelectric conversion cell
3: sealing material layer
3A: sealing material sheet (i)
3B: sealing material sheet (ii)
31 a: transparent resin layer (a)
31b: transparent resin layer (b)
4: front protective member
5: rear protective member

**Claims**

**1.** A sealing material sheet for a solar cell module, comprising:

a transparent resin (A) exhibiting a melt flow rate (190°C, 2.16 kg load) of 10 to 20 g/10 min; and
a transparent resin (B) exhibiting a melt flow rate (190°C, 2.16 kg load) of 30 to 40 g/10 min, and
the mass ratio $\alpha$ (=$W_A/W_B$) of the transparent resin (A) (mass: $W_A$) and the transparent resin (B) (mass: $W_B$) being 0.7 to 1.5.

**2.** The sealing material sheet according to Claim 1, wherein the sealing material sheet comprises a mixed resin layer comprising a mixed resin of the transparent resin (A) and the transparent resin(B).

**3.** The sealing material sheet according to Claim 1, wherein the sealing material sheet comprises a laminate in which a transparent resin layer (a) comprising the transparent resin (A) and a transparent resin layer (b) comprising the transparent resin (B) are laminated such that at least one of foremost layers of the laminate is the transparent resin layer (b).

**4.** The sealing material sheet according to Claim 3, wherein the laminate is formed by coextrduing the transparent resin (A) and the transparent resin (B).

**5.** The sealing material sheet according to any one of Claims 1 to 4, wherein the thickness is 10 to 500 $\mu$m.

**6.** A method of manufacturing a solar cell module comprising:

a sealing step of heating and pressing in a state where a photoelectric conversion cell is interposed between the sealing material sheets for a solar cell module according to Claim 1 to seal the photoelectric conversion cell by the sealing material sheet for a solar cell module.

7.  The method according to Claim 6,
    wherein the photoelectric conversion cell is interposed between the sealing material sheets for a solar cell module according to Claim 3 or 4 such that the transparent resin layer (b) of the foremost layer of the sealing material sheet for a solar cell module turns toward the photoelectric conversion cell.

# FIG. 1

<u>1</u>

# FIG. 2

<u>1A</u>

# FIG. 3

1B

4
31a ⎫ 3B
31b ⎭
2
2
31b ⎫ 3B
31a ⎭
5

# FIG. 4

4
3A
3A
5

# FIG. 5

<table>
<tr><td colspan="2" align="center">**INTERNATIONAL SEARCH REPORT**</td><td colspan="2">International application No.<br>PCT/JP2010/066301</td></tr>
</table>

A.  CLASSIFICATION OF SUBJECT MATTER
*H01L31/042*(2006.01)i

According to International Patent Classification (IPC) or to both national classification and IPC

B.  FIELDS SEARCHED

Minimum documentation searched (classification system followed by classification symbols)
H01L31/042

Documentation searched other than minimum documentation to the extent that such documents are included in the fields searched
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | JP 2008-117925 A  (Sekisui Film Kabushiki Kaisha),<br>22 May 2008 (22.05.2008),<br>entire text; all drawings<br>(Family: none) | 1-7 |
| A | JP 2005-50927 A  (Kyocera Corp.),<br>24 February 2005 (24.02.2005),<br>claims; paragraphs [0100] to [0153]<br>(Family: none) | 1-7 |
| A | JP 2005-159181 A  (Kyocera Corp.),<br>16 June 2005 (16.06.2005),<br>paragraphs [0075] to [0086]<br>(Family: none) | 1-7 |

☐ Further documents are listed in the continuation of Box C.   ☐ See patent family annex.

| | | |
|---|---|---|
| * | Special categories of cited documents: | |
| "A" | document defining the general state of the art which is not considered to be of particular relevance | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search<br>14 October, 2010 (14.10.10) | Date of mailing of the international search report<br>26 October, 2010 (26.10.10) |
|---|---|
| Name and mailing address of the ISA/<br>Japanese Patent Office | Authorized officer |
| Facsimile No. | Telephone No. |

Form PCT/ISA/210 (second sheet) (July 2009)

## REFERENCES CITED IN THE DESCRIPTION

**Patent documents cited in the description**

- JP 2009224022 A
- WO 06095762 A
- WO 01061763 A